# EUROPEAN PATENT APPLICATION

(11) **EP 4 509 851 A1**
(43) Date of publication of application: **19.02.2025**
(21) Application number: 23820154.5
(22) Date of filing: 09.06.2023
(51) Int. Cl.: G01R 31/385, G01R 31/392, G01R 31/01, G01R 31/00

(54) **BATTERY CELL INSPECTION SYSTEM**

(30) Priority: 10.06.2022 KR 20220070545
(71) Applicant: LG Energy Solution, Ltd., Seoul 07335 (KR)
(72) Inventor: KIM, Myung-Ki, Daejeon 34122 (KR)
(74) Representative: Goddar, Heinz J.
(86) International application number: PCT/KR2023/007984
(87) International publication number: WO 2023/239219

(57) **Abstract**

A battery cell inspection system according to the present disclosure includes a transport unit including a plurality of conveyors arranged in multiple levels in a vertical direction, and configured to transport a tray on which an assembled battery cell is mounted; a cell inspection unit placed in stack corresponding to the multiple levels of the transport unit, and configured to perform pre-charging and cell defect inspection of the battery cell; and a shuttle configured to move between the cell inspection unit and the transport unit to carry the tray into the cell inspection unit or take the tray from the cell inspection unit.

## Description

### TECHNICAL FIELD

The present application claims priority to Korean Patent Application No. 10-2022-0070545 filed on June 10, 2022 in the Republic of Korea, the disclosures of which are incorporated herein by reference.

The present disclosure relates to a battery cell inspection system, and more particularly, to a battery cell inspection system with improved spatial density and battery production efficiency by improving a logistics movement path and an inspection path in a formation process for activation and operation inspection of an assembled battery cell.

### BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance secondary batteries that can be recharged repeatedly.

Currently, commercially available secondary batteries include nickel-cadmium batteries, nickel-hydrogen batteries, nickel-zinc batteries, lithium ion secondary batteries and the like. Among them, lithium ion secondary batteries have little or no memory effect, and thus they are gaining more attention than nickel-based secondary batteries for their advantages that recharging can be done whenever it is convenient, the self-discharge rate is very low and the energy density is high. The lithium ion secondary batteries primarily include lithium-based oxides and carbon materials for a positive electrode active material and a negative electrode active material, respectively. The assembly of the lithium ion secondary batteries is performed by receiving an electrode assembly in a case together with an electrolyte material, wherein the electrode assembly includes a positive electrode plate and a negative electrode plate coated respectively with the positive electrode active material and the negative electrode active material and a separator interposed between the positive electrode plate and the negative electrode plate.

Meanwhile, the assembled battery cell undergoes a formation process for cell activation and operation inspection.

However, according to the conventional process, cell activation and operation inspection is performed while a single level tray on which assembled battery cells are mounted is primarily being transported using a conveyor, resulting in low spatial density, long inspection time and slow inspection speed, which increases the takt time of the formation process and reduces the battery cell production efficiency.

### SUMMARY

### Technical Problem

The present disclosure is designed to solve the above-described problem, and therefore the present disclosure is directed to providing a battery cell inspection system having an improved structure of receiving a plurality of assembled battery cells transported, and simultaneously carrying a plurality of trays to and from a cell inspection unit, thereby improving the spatial density and the production efficiency of the entire battery inspection system.

However, the technical problem to be solved by the present disclosure is not limited to the above-described problems, and these and other problems will be clearly understood by those skilled in the art from the following description.

### Technical Solution

A battery cell inspection system according to the present disclosure includes a transport unit including a plurality of conveyors arranged in multiple levels in a vertical direction, and configured to transport a tray on which an assembled battery cell is mounted; a cell inspection unit placed in stack corresponding to the multiple levels of the transport unit, and configured to perform pre-charging and cell defect inspection of the battery cell; and a shuttle configured to move between the cell inspection unit and the transport unit to carry the tray into the cell inspection unit or take the tray from the cell inspection unit.

The shuttle may convey a plurality of trays when performing an operation of carrying to the cell inspection unit once or an operation of taking from the cell inspection unit once.

The shuttle may be multiple levels corresponding to the transport unit and the cell inspection unit, and each of the multiple levels of the shuttle may convey at least one tray.

The transport unit may be disposed on a carry-in path and a carry-out path of the cell inspection unit.

The transport unit may include a first transport conveyor; and a second transport conveyor disposed vertically on the first transport conveyor.

The cell inspection unit may include a first inspection device disposed at a height corresponding to the first transport conveyor; and a second inspection device placed on the first inspection device and disposed at a height corresponding to the second transport conveyor.

Each of the first inspection device and the second inspection device may include a pin plate disposed on the tray and having a plurality of electrodes exposed; a bottom plate configured to support the tray and spaced a predetermined distance apart from the pin plate; and an up/down movement unit connecting the bottom plate to the pin plate, and configured to decrease or increase the distance between the bottom plate and the pin plate.

Each of the first inspection device and the second inspection device may further include a jig unit disposed on the bottom plate and configured to support and align the tray.

The up/down movement unit may include a cylinder; a rod having an end connected to the cylinder and an opposite end coupled to the bottom plate; and a fixing block coupled to the bottom plate and configured to fix the opposite end of the rod.

The jig unit may include a jig plate on which the tray is seated; and a ratchet fastener configured to fix two sides of the tray seated on the jig plate when rotated.

The jig unit further may include a stopper to limit movement in a direction of carrying the tray into the jig plate.

A plurality of cell inspection units may be arranged in a line.

The shuttle may move in parallel to the lengthwise arrangement of the plurality of cell inspection units.

The shuttle may include a body having a moving wheel; a first carrying unit disposed at a height corresponding to the first transport conveyor and the first inspection device; and a second carrying unit disposed a height corresponding to the second transport conveyor and the second inspection device.

Each of the first carrying unit and the second carrying unit may include a pair of guide rails spaced apart from each other by a width of the tray; a fork for gripping disposed slidably movably along the guide rails and configured to grip two sides of the tray; and a fork driving unit configured to drive the fork for gripping.

The fork for gripping may move from the body in a direction perpendicular to a movement direction of the shuttle.

The cell defect inspection may include causing a predetermined amount of current to flow in the battery cell, detecting a voltage change of the battery cell and determining a presence or absence of a defect.

The battery cell may include an electrode assembly including a negative electrode plate, and the pre-charging may include charging the battery cell in a predetermined amount to form an electric charge layer on the negative electrode plate to prevent formation of an electron movement channel by oxidation of metal impurities.

The battery cell may be a cylindrical battery.

### Advantageous Effects

According to an aspect of the present disclosure, it may be possible to form an improved structure of receiving a plurality of assembled battery cells transported, and simultaneously carrying a plurality of trays to the cell inspection unit and taking the plurality of trays from the cell inspection unit, thereby improving the spatial density and the production efficiency of the entire battery inspection system.

Additionally, the plurality of trays may be simultaneously inspected by the cell inspection unit that performs cell defect inspection and pre-charging, so it may be possible to reduce the space occupied by the inspection machine, thereby improving the space efficiency of the battery inspection system.

Additionally, according to an aspect of the present disclosure, the plurality of trays on which the battery cells are mounted may be simultaneously carried to and from the cell inspection unit each time, so it may be possible to reduce the inspection time and improve the inspection speed, thereby reducing the takt time of the battery cell formation process and increasing the battery cell production efficiency.

### BRIEF DESCRIPTION OF THE DRAWINGS

The accompanying drawings illustrate exemplary embodiments of the present disclosure and together with the following detailed description, serve to provide a further understanding of the technical aspect of the present disclosure, and thus the present disclosure should not be construed as being limited to the drawings.
FIG. 1 is a plan view showing the layout of a battery cell inspection system according to an embodiment of the present disclosure.
FIG. 2 is a diagram schematically showing a battery inspection system according to an embodiment of the present disclosure.
FIG. 3 is a perspective view of a tray having battery cells that will be supplied to a battery cell inspection system according to an embodiment of the present disclosure.
FIG. 4 is a perspective view of a cell inspection unit of a battery inspection system according to an embodiment of the present disclosure.
FIG. 5 is a front view of a cell inspection unit of a battery inspection system according to an embodiment of the present disclosure.
FIGS. 6 and 7 are top views of a bottom plate and a jig unit of a cell inspection unit of a battery inspection system according to an embodiment of the present disclosure.
FIG. 8 is a perspective view of a shuttle of a battery inspection system according to an embodiment of the present disclosure.
FIGS. 9 and 10 are diagrams showing a tray lifted by a fork for gripping and a protruding portion of a shuttle of a battery inspection system according to an embodiment of the present disclosure.
FIGS. 11 to 13 are diagrams showing an example in which a cell inspection unit of a battery inspection system according to an embodiment of the present disclosure accommodates trays from a transport unit and performs cell defect inspection and pre-charging.

### DETAILED DESCRIPTION

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, but rather interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspect of the present disclosure and are not intended to be limiting, so it should be understood that a variety of other equivalents and modifications could have been made thereto at the time that the application was filed.

In the drawings, each element or a specific portion of the element may be exaggerated, omitted or schematically depicted for convenience of description and clarity. Accordingly, each element may not be shown at true scale size. When it is determined that a certain detailed description of related known functions or elements may unnecessarily obscure the subject matter of the present disclosure, the description is omitted.

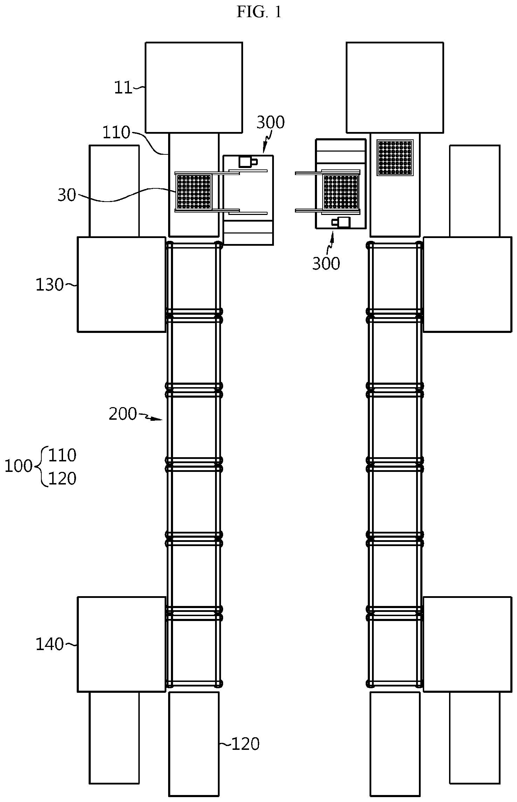

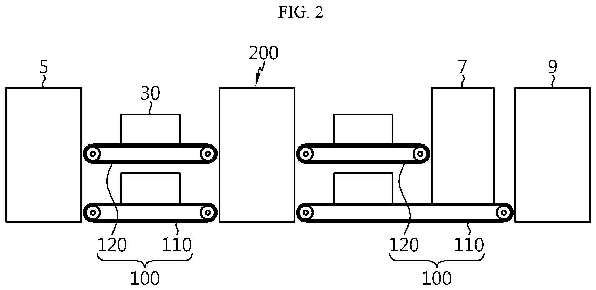

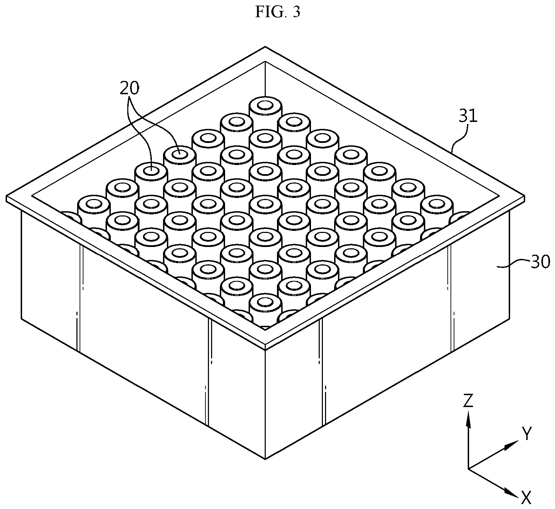

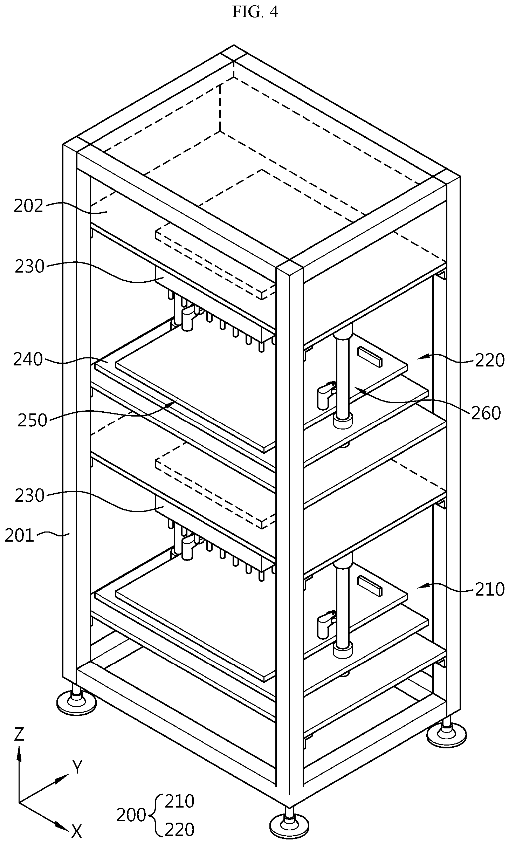

FIG. 1 is a plan view showing the layout of a battery cell inspection system according to an embodiment of the present disclosure, FIG. 2 is a diagram schematically showing a battery inspection system according to an embodiment of the present disclosure, FIG. 3 is a perspective view of a tray having battery cells that will be supplied to the battery cell inspection system according to an embodiment of the present disclosure, and FIG. 4 is a perspective view of a cell inspection unit of the battery inspection system according to an embodiment of the present disclosure.

Referring to FIGS. 1 to 3, the battery cell inspection system according to an embodiment of the present disclosure includes a tray 30 on which a battery cell 20 to be inspected is mounted, a transport unit 100 to transport the tray 30, the cell inspection unit 200 recieves and inspects the battery cell 20, and a shuttle 300 to convey the tray 30 to the transport unit 100 and the cell inspection unit 200.

The object to be inspected by the battery inspection system according to an embodiment of the present disclosure will be described. The battery cell 20 may be a secondary battery, for example, a pouch type secondary battery, a prismatic secondary battery or a cylindrical secondary battery. Hereinafter, this embodiment will be described based on cylindrical secondary batteries as the battery cells 20 as shown in FIG. 3.

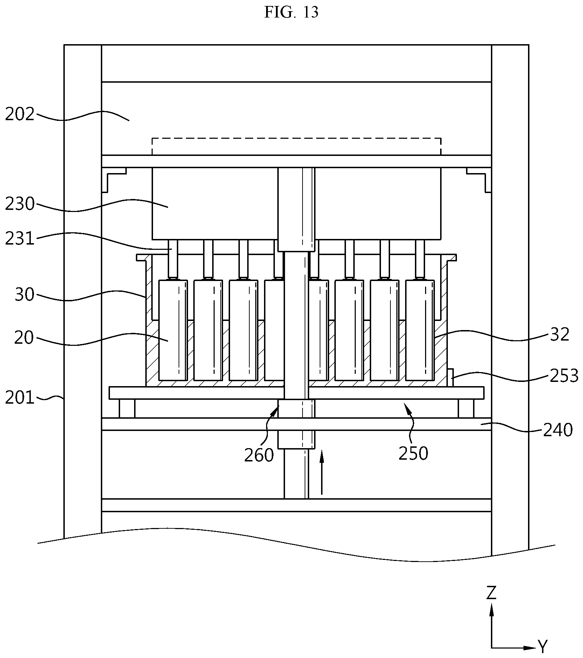

The tray 30 may be where the assembled battery cells 20 are mounted. The tray 30 may be approximately rectangular or square in shape when viewed from the top, and may accommodate the plurality of battery cells 20. The tray 30 may have seating grooves 32 (see FIG. 13) in which the battery cells 20 are seated. The seating groove 32 may support and secure each battery cell 20.

The number of battery cells 20 mounted in the tray 30 may vary, and in the drawing, the number of battery cells 20 that may be mounted in a tray may be 8 * 8, 64. The height of the battery cells 20 mounted in the tray 30 may be lower than the top of the tray 30 and may be at the level of 80 to 90 % of the thicknesswise height of the tray 30.

Referring primarily to FIGS. 1 and 2, the transport unit 100 may transport the tray 30 in which the assembled battery cells 20 are mounted. The transport unit 100 may be disposed on a carry-in path and a carry-out path of the cell inspection unit 200. That is, the transport unit 100 may be configured to transport the tray 30 from an assembly unit 5 to a location for taking the tray 30 to the cell inspection unit 200, and the transport unit 100 may be configured to transport the tray 30 from a location at which the tray 30 is taken from the cell inspection unit 200 to a post-process (for example, an aging machine 9 or a charging/discharging process). Meanwhile, a station 11 (or a lift) may be disposed between the assembly unit 5 and the transport unit 100 as shown in FIG. 1.

The transport unit 100 may include a plurality of conveyors arranged in multiple levels in the vertical direction. The transport unit 100 transports each tray 30 in a single level, and may have a multistorey, multilevel structure for simultaneously transporting the trays 30 at different heights. To this end, the transport unit 100 may include the plurality of conveyors arranged in parallel in the vertical direction.

Hereinafter, this embodiment will be described based on two conveyors and accordingly, the cell inspection unit 200 and the shuttle 300 in two levels.

Referring primarily to FIG. 2, the transport unit 100 may include a first transport conveyor 110, and a second transport conveyor 120 disposed vertically above the first transport conveyor 110. A single level tray 30 may be loaded on each of the first transport conveyor 110 and the second transport conveyor 120.

Meanwhile, at least one (one tray 30 in FIG. 2) single level tray 30 may be disposed on each of the first transport conveyor 110 and the second transport conveyor 120, and may change by adjusting the transport length of the first transport conveyor 110 and the second transport conveyor 120. That is, when the length of the conveyor increases, the length of the first transport conveyor 110 and the second transport conveyor 120 is longer than that of FIG. 2, and in this case, the number of trays 30 placed in each transport conveyor 110, 120 may increase.

Due to the double level structure of the transport unit 100 in this embodiment, it may be possible to improve the process of carrying the tray 30 to and from the cell inspection unit 200. That is, two trays 30, each loaded on each of the first transport conveyor 110 and the second transport conveyor 120, may be simultaneously carried to the cell inspection unit 200 or taken from the cell inspection unit 200 to the transport unit 100. Accordingly, the longer conveyor may be used as a buffer space in which the trays 30 accumulate on the conveyor, thereby minimize the reduction in space utilization.

Further, compared to one conveyor, each one tray 30 on each of the first transport conveyor 110 and the second transport conveyor 120, totaling two trays 30 may be simultaneously carried to or from the cell inspection unit 200, so it may be possible to reduce the inspection time and improve the inspection speed, thereby improving the overall battery production efficiency.

Hereinafter, the formation process for activation and operation inspection of the assembled battery cells 20 will be briefly described. The formation process largely includes pre-charging/low current inspection of the battery cells 20, followed in a sequential order by , aging through a loaded item 7 loaded in multilayer and the aging machine 9, and charging/discharging. Here, pre-charging and low current inspection may be performed at the early step of the formation process.

The pre-charging may prevent the formation of an electron movement channel by oxidation of metal impurities by charging the battery cells 20 in a predetermined amount to form an electric charge layer on the negative electrode plate. Additionally, the cell defect inspection may determine the presence or absence of defects by detecting a voltage change of the battery cells 20 after the flow of the predetermined amount of current in the battery cells 20. Through the cell inspection unit 200, the pre-charging and low current inspection process may be performed.

The cell inspection unit 200 may be a device that performs cell defect inspection and pre-charging of the battery cells 20. Referring primarily to FIG. 1, a plurality of cell inspection units 200 may be arranged in a line. In the drawing, six cell inspection units are arranged in the up-down direction and two inspection lines are symmetrically arranged. Additionally, buffer units 130, 140 may be disposed on one side of the cell inspection unit 200.

Referring primarily to FIG. 4, the cell inspection unit 200 may include a first inspection device 210 disposed at a height corresponding to the first transport conveyor 110; and a second inspection device 220 placed on the first inspection device 210 and disposed at a height corresponding to the second transport conveyor 120.

The cell inspection unit 200 may be a double level corresponding to the first transport conveyor 110 and the second transport conveyor 120. Accordingly, the first inspection device 210 and the second inspection device 220 may be disposed in a lower area and an upper area within a frame 201 and vertically stacked on top of each other. The height to which the first inspection device 210 and the second inspection device 220 accommodate the tray 30 may correspond to the height to which the tray 30 is seated in the first transport conveyor 110 and the second transport conveyor 120, respectively.

The first inspection device 210 and the second inspection device 220 may have the same structure. That is, each of the first inspection device 210 and the second inspection device 220 may include a pin plate 230 having exposed electrodes 231, a bottom plate 240 configured to support the tray 30, and an up/down movement unit 260 connecting the bottom plate 240 to the pin plate 230.

A power unit 202 may be placed on top of the lower area and the upper area of the frame 201. The power unit 202 may supply power to the electrodes 231 of the pin plate 230. The power may be current and voltage supplied for cell defect inspection and pre-charging.

The pin plate 230 may contact the lower surface of the power unit 202. The pin plate 230 may extend downwards from the lower surface of the power unit 202. The plurality of electrodes 231 may be exposed and arranged on bottom of the pin plate 230.

The bottom plate 240 may be spaced a predetermined distance apart from the pin plate 230. The jig unit 250 may be disposed on the upper surface of the bottom plate 240. The jig unit 250 may place, support and align the tray 30.

The up/down movement unit 260 is a device that connects the bottom plate 240 to the pin plate 230. The up/down movement unit 260 may be configured to decrease or increase the distance between the bottom plate 240 and the pin plate 230. For example, with the bottom plate 240 placed in a fixed state, as the pin plate 230 is moved down by the up/down movement unit 260, the distance between the bottom plate 240 and the pin plate 230 may decrease. On the contrary, with the pin plate 230 placed in a fixed state, as the bottom plate 240 is moved up by the up/down movement unit 260, the distance between the bottom plate 240 and the pin plate 230 may decrease.

Accordingly, it may be possible to form an improved structure of placing the assembled battery cells 20 transported in the two trays 30 and simultaneously carrying the plurality of trays 30 to and from the cell inspection unit 200, thereby improving the spatial density and the production efficiency of the entire battery cell inspection system.

Additionally, the cell inspection unit 200 that performs cell defect inspection and pre-charging may simultaneously inspect the battery cells 20 loaded on the two trays 30, thereby reducing the space occupied by the inspection machine and improving the space efficiency of the battery inspection system. That is, since the first inspection device 210 and the second inspection device 220 are vertically stacked in two levels on top of each other, it requires a space as large as the first inspection device 210 in the horizontal direction, so it may be possible to reduce the equipment space of the cell inspection unit 200 and the entire battery inspection system.

The shuttle 300 may be a device that moves between the cell inspection unit 200 and the transport unit 100. The shuttle 300 may carry the tray 30 to the cell inspection unit 200 or take the tray 30 from the cell inspection unit 200. The shuttle 300 may convey the plurality of trays 30 when performing an operation of carrying to the cell inspection unit 200 once or an operation of taking from the cell inspection unit 200 once.

Additionally, the shuttle 300 may be multiple levels corresponding to the transport unit 100 and the cell inspection unit 200, and may convey at least one tray 30 for each level (storey) of the shuttle 300. As shown in FIG. 2, the shuttle 300 may be two levels corresponding to the two levels of the transport unit 100, and may convey at least one tray 30 for each of the two levels.

By the above-described exemplary configuration, it may be possible to form an improved structure of receiving two assembled battery cells 20 transported and simultaneously carrying two trays 30 to and from the cell inspection unit 200, thereby improving the spatial density and the production efficiency of the entire battery inspection system.

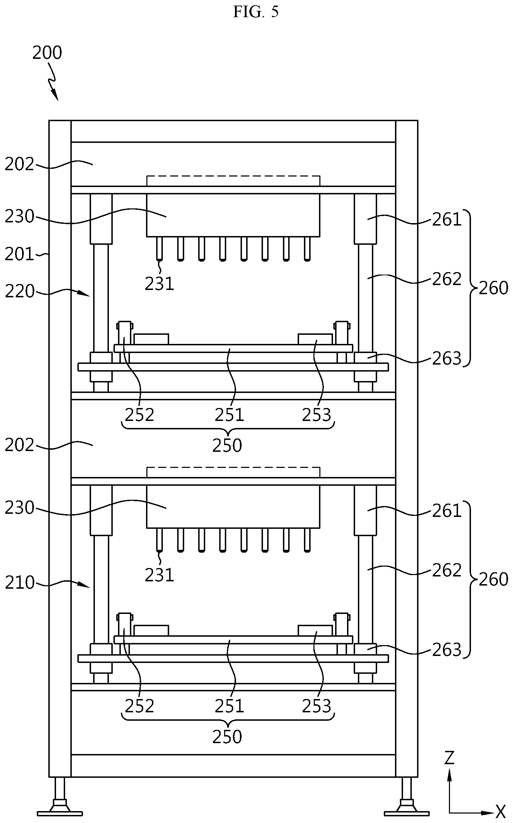

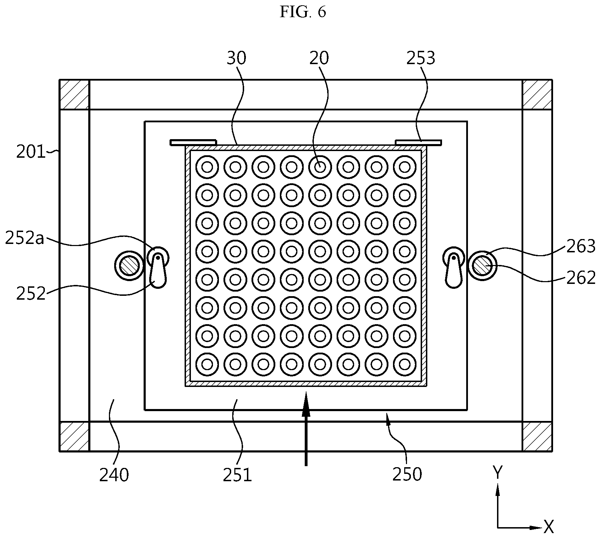

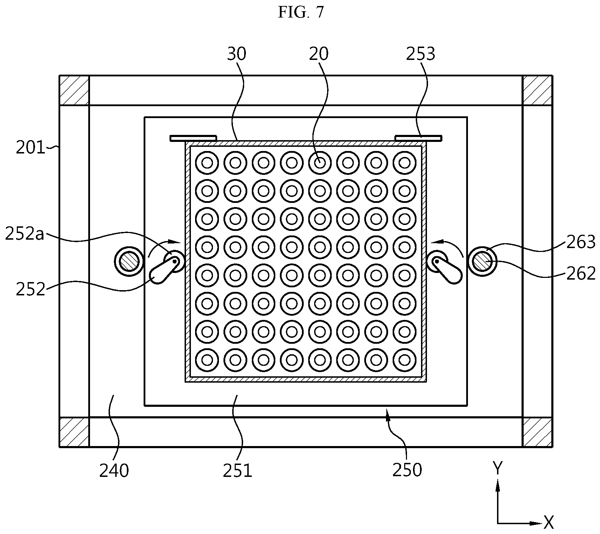

FIG. 5 is a front view of the cell inspection unit of the battery inspection system according to an embodiment of the present disclosure, and FIGS. 6 and 7 are top views of the bottom plate and the jig unit of the cell inspection unit of the battery inspection system according to an embodiment of the present disclosure.

The cell inspection unit 200 of the battery cell inspection system according to this embodiment will be described below in detail with reference to FIGS. 5 to 7 and FIG. 4.

Referring to FIGS. 5 and 6, the cell inspection unit 200 may include the first inspection device 210 disposed at the height corresponding to the first transport conveyor 110, and the second inspection device 220 placed on the first inspection device 210 and disposed at the height corresponding to the second transport conveyor 120.

Each of the first inspection device 210 and the second inspection device 220 may include the pin plate 230 disposed in the upper part of the body and having the plurality of exposed electrodes 231; the bottom plate 240 spaced the predetermined distance apart from the pin plate 230; and the up/down movement unit 260 to move the bottom plate 240 up/down to the pin plate 230.

Since the first inspection device 210 and the second inspection device 220 have the same structure, only the first inspection device 210 will be described in detail below.

The pin plate 230 may be disposed in the lower area of the frame 201. The pin plate 230 may be connected to the power unit 202 located thereon, and may extend downwards from the power unit 202. The plurality of electrodes 231 may be exposed and arranged on the bottom of the pin plate 230. Each of the plurality of electrodes 231 may correspond to each of the battery cells 20. Additionally, the electrodes 231, each corresponding to each battery cell 20, may be an assembly of one or more electrodes 231. For example, the assembly of electrodes 231 may include positive and negative electrodes 231 and a temperature sensor, and for convenience, only one electrode 231 is shown in the drawing.

The bottom plate 240 may be spaced the predetermined distance apart from the pin plate 230. The bottom plate 240 may be configured to move up to the pin plate 230 or down from the pin plate 230. The jig unit 250 may be disposed on the bottom plate 240. Additionally, a fixing block 263 may be placed on two sides of the bottom plate 240.

The up/down movement unit 260 may include a cylinder 261, a rod 262 having one end connected to the cylinder 261 and the other end coupled to the bottom plate 240 and the fixing block 263 coupled to the bottom plate 240 and configured to fix the other end of the rod 262.

The rod 262 may have one end connected to the cylinder 261 and the other end coupled to the bottom plate 240. The fixing block 263 may be disposed in the bottom plate 240 and configured to fix the other end of the rod 262. Through the up/down movement unit 260, the distance between the bottom plate 240 and the pin plate 230 may decrease or increase. In this embodiment, by the operation of the cylinder 261, the rod 262 may be extended out and the fixing block 263 fixed to the other end may be moved up/down. Accordingly, with respect to the pin plate 230, the bottom plate 240 moves up/down.

Additionally, the first inspection device 210 may further include the jig unit 250 disposed in the bottom plate 240. The jig unit 250 may support and align the tray 30. Referring to FIGS. 5 and 6, the jig unit 250 may include a jig plate 251 on which the tray 30 is seated, a ratchet fastener 252 configured to fix two sides of the tray 30 seated on the jig plate 251 when rotated, and a stopper 253 configured to limit movements in a direction of carrying the tray 30 into the jig plate 251.

The jig plate 251 may be disposed on the bottom plate 240 and spaced a predetermined distance apart from the bottom plate 240. The tray 30 may be seated on the jig plate 251.

The ratchet fastener 252 may be disposed on two sides of the jig plate 251. The ratchet fastener 252 may align the tray 30 in position when the tray 30 enters the first inspection device 210. When the tray 30 is seated on the jig plate 251, the ratchet fastener 252 may rotate around a rotation axis on one side and an alignment roller 252a may press the two sides of the tray 30 as shown in FIG. 7. Accordingly, alignment of the tray 30 in the left-right direction may be achieved.

The stopper 253 may be disposed in the upper area of the jig plate 251 as shown in FIGS. 6 and 7. The stopper 253 may limit movements in the direction of carrying the tray 30 into the first inspection device 210. In the drawing, the direction of carrying the tray 30 faces upward, and the stopper 253 is disposed in the upper area of the jig plate 251, so it may be possible to hold the top of the tray 30 being carried, thereby achieving alignment of the tray 30 in the up-down direction.

By the ratchet fastener 252 and the stopper 253 configured as described above, it may be possible to make it easy to align the tray 30 in position on the jig plate 251, thereby enabling the first inspection device 210 to easily perform pre-charging and cell defect inspection of the battery cells 20.

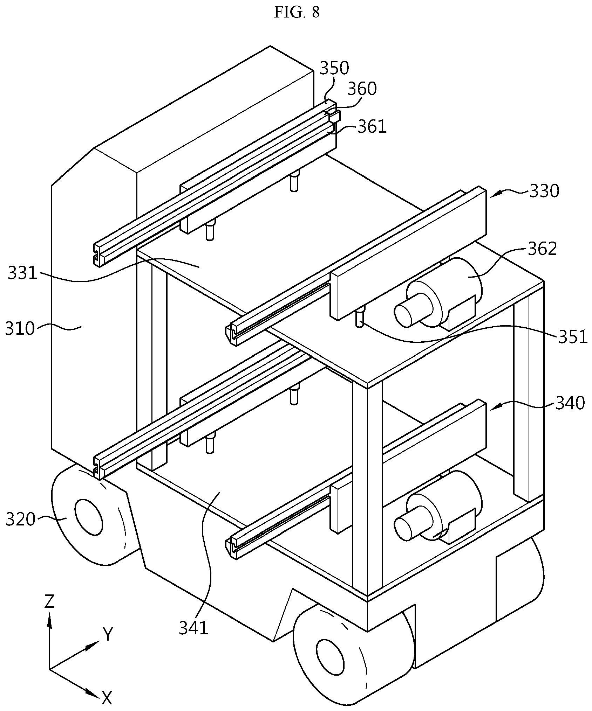

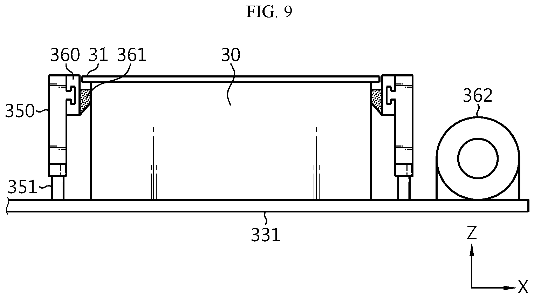

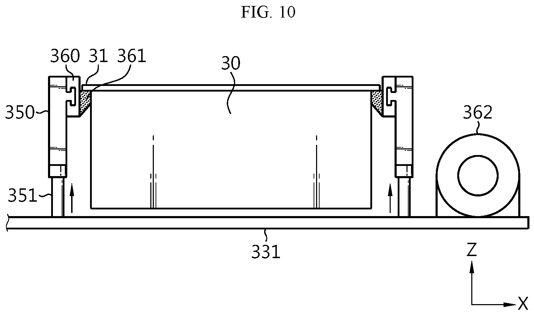

FIG. 8 is a perspective view of the shuttle of the battery inspection system according to an embodiment of the present disclosure, and FIGS. 9 and 10 are diagrams showing the tray lifted by a fork for gripping 360 and a protruding portion 361 of the shuttle of the battery inspection system according to an embodiment of the present disclosure.

Referring primarily to FIG. 8, the shuttle 300 may be two levels corresponding to the two levels of the transport unit 100 and the cell inspection unit 200. To this end, the shuttle 300 may include a body 310 having a moving wheel 320; a first carrying unit 330 disposed at a height corresponding to the first transport conveyor 110 and the first inspection device 210; and a second carrying unit 340 disposed at a height corresponding to the second transport conveyor 120 and the second inspection device 220.

The body 310 may have the moving wheel 320 to help the shuttle 300 to move in at least one direction.

The first carrying unit 330 and the second carrying unit 340 have the same structure, and the structure of the second carrying unit 340 will be described below. Referring primarily to FIG. 8, the second carrying unit 340 may include a pair of guide rails 350 spaced apart from each other by the width of the tray 30; the fork for gripping 360 disposed slidably movably along the guide rails 350 and configured to grip two sides of the tray 30; and a fork driving unit 362 to drive the fork for gripping 360.

The second carrying unit 340 may include a support plate, and the guide rails 350 may be coupled to the support plate movably upward/downward. The support plate may include a rail lift 351.

The guide rails 350 may be spaced apart from each other by the width of the tray 30. One end of the guide rails 350 may extend from one side beyond the width (the width in the Y axis direction) of the shuttle 300. The guide rails 350 may be configured to guide the slidable movement of the fork for gripping 360 during the movement of the fork for gripping 360, and support an external force (the weight of the tray 30) applied to the fork for gripping 360.

The fork for gripping 360 is the component that grips and conveys the tray 30. The fork for gripping 360 may be coupled to the guide rails 350 slidably movably along the guide rails 350. The fork for gripping 360 may move from the body 310 in a direction perpendicular to the movement direction of the shuttle 300.

The fork for gripping 360 may have the protruding portion 361 on one surface thereof, and the protruding portion 361 may be fit-coupled to a stopper step 31 of the tray 30. Referring to FIGS. 9 and 10, the protruding portion 361 may slightly lift the tray 30 by upward movement from the stopper step 31 of the tray 30.

The second carrying unit 340 may convey one tray 30 when performing an operation of carrying to or from the cell inspection unit 200 once. Additionally, as shown in FIG. 8, likewise, the first carrying unit 330 disposed vertically below the second carrying unit 340 may convey one tray 30. That is, as shown in FIG. 1, the shuttle 300 may simultaneously carry two trays 30 into the cell inspection unit 200, each one tray 30 for each of the first carrying unit 330 and the second carrying unit 340 in the operation of carrying once, and may take the two trays 30 from the cell inspection unit 200 by the reverse operation. The shuttle 300 may move in parallel to the lengthwise arrangement of the two cell inspection units 200.

Through the shuttle 300 configured as described above, it may be possible to form a structure of placing the assembled battery cells 20 transported in the two trays 30 and simultaneously carrying the plurality of trays 30 to and from the cell inspection unit 200. Accordingly, it may be possible to improve the spatial density and the production efficiency of the entire battery inspection system.

Additionally, since each of the first transport conveyor 110 and the second transport conveyor 120 transports each tray 30 and the total of two trays 30 are simultaneously carried to and from the first inspection device 210 and the second inspection device 220, it may be possible to reduce the time required to carry the battery cells 20 and perform the pre-charging and operation inspection process of the battery cells 20 quickly and efficiently.

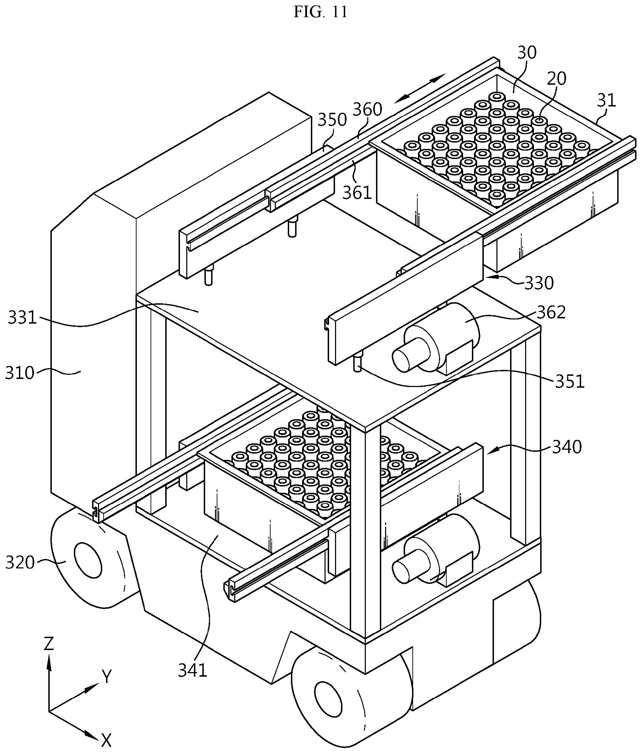

FIGS. 11 to 13 are diagrams showing an example in which the cell inspection unit of the battery inspection system according to an embodiment of the present disclosure accommodates the trays from the transport unit and performs cell defect inspection and pre-charging.

Hereinafter, the inspection process of the battery cells 20 through the battery cell inspection system according to this embodiment will be described with reference to FIGS. 1 to 13.

First, as shown in FIG. 2, each one tray 30 is transported from the assembly unit 5 to the first transport conveyor 110 and the second transport conveyor 120 of the transport unit 100. The tray from the assembly unit 5 may be temporarily loaded on the station 11 (see FIG. 1).

Subsequently, the shuttle 300 approaches the transport unit 100 and the fork for gripping 360 of each of the first carrying unit 330 and the second carrying unit 340 grips the tray 30 on each of the first transport conveyor 110 and the second transport conveyor 120. Specifically, the fork for gripping 360 in FIG. 8 moves in a direction perpendicular to the movement direction of the shuttle 300 from the body 310 by the operation of the fork driving unit 362. The fork for gripping 360 slidably moves in the Y axis direction, and although not shown, approaches the tray 30 on the two levels of the transport unit 100.

Additionally, as shown in FIGS. 9 and 10, the rail lift 351 pushes up the guide rails 350 and accordingly the protruding portion 361 of the fork for gripping 360 is fitted into the stopper step 31 of the tray 30 and lifts up the tray 30. Additionally, as shown in FIG. 11, the fork for gripping 360 moves to the body 310 again and is seated in the shuttle 300. The first carrying unit 330 in the seated state is shown. This operation may be performed by the first carrying unit 330 and the second carrying unit 340 at the same time, and for convenience of description, only the operation of the second carrying unit 340 is shown.

Subsequently, the shuttle 300 moves to the empty cell inspection unit 200 as shown in FIG. 2.

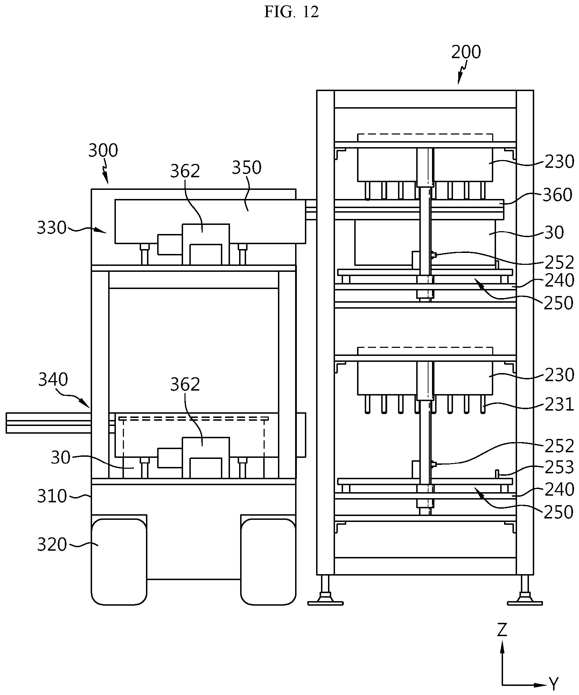

Subsequently, the shuttle 300 carries the tray 30 into the cell inspection unit 200, and specifically, as shown in FIG. 12, the fork for gripping 360 of the second carrying unit 340 slidably moves to the second inspection device 220 and moves the tray 30 being gripped to the upper surface of the jig unit 250 of the second inspection device 220. During the movement of the tray 30, the stopper 253 in FIG. 7 is fitted into an upper region of the tray 30 to limit the upward movement of the tray 30. Additionally, as shown in FIG. 8, the rail lift 351 moves down to seat the tray 30 on the upper surface of the jig unit 250.

In this instance, as shown in FIGS. 6 and 7, the ratchet fastener 252 slightly rotates and the alignment roller 252a presses the two sides of the tray 30, completing the alignment of the tray 30 in the left-right direction. The process of carrying the tray 30 into the cell inspection unit 200 may be performed by not only the second inspection device 220 but also the first inspection device 210.

Subsequently, the cell inspection unit 200 performs pre-charging and cell defect inspection of the battery cells 20. Referring to FIG. 13, the rod 262 is reduced by the operation of the cylinder 261 and the fixing block 263 fixed to the other end moves up, and accordingly, with respect to the pin plate 230, the bottom plate 240 moves up. The battery cells 20 electrically contact the electrodes 231 on the pin plate 230. Subsequently, the pre-charging and cell defect inspection of the battery cells 20 is performed.

Meanwhile, when the cell inspection unit 200 completes the inspection, the process of taking the tray 30 from the cell inspection unit 200 is performed. The process of taking the tray 30 from the cell inspection unit 200 is performed in the opposite order to the process of carrying the tray 30 into the cell inspection unit 200, and finally, the tray 30 is taken to the first transport conveyor 110 and the second transport conveyor 120 of the transport unit 100 on the carry-out path, and the trays 30 may be loaded in multilayer to form the loaded item 7, followed by aging through the aging machine 9 and the post-process such as the charging/discharging process in a sequential order.

By the above-described exemplary configuration, it may be possible to form a structure of placing the assembled battery cells 20 transported in the two trays 30 and simultaneously carrying the plurality of trays 30 to and from the cell inspection unit 200. Accordingly, it may be possible to improve the spatial density and the production efficiency of the entire battery inspection system.

Additionally, the cell inspection unit 200 that performs cell defect inspection and pre-charging may simultaneously inspect the battery cells 20 loaded on the two trays 30, thereby reducing the space occupied by the inspection machine and improving the space efficiency of the battery inspection system.

By the above-described exemplary configuration, it may be possible to simultaneously carry two trays 30 on which the battery cells 20 are mounted to and from the cell inspection unit 200, thereby reducing the inspection time and improving the inspection speed, resulting in reduced takt time of the formation process of the battery cells 20 and increased production efficiency of the battery cells 20.

While the present disclosure has been hereinabove described with regard to a limited number of embodiments and drawings, the present disclosure is not limited thereto and it is apparent that a variety of changes and modifications may be made by those skilled in the art within the technical aspect of the present disclosure and the scope of the appended claims and their equivalents.

The terms indicating directions such as upper, lower, left, right, front and rear are used for convenience of description, but it is obvious to those skilled in the art that the terms may change depending on the position of the stated element or an observer.

## Claims

1. A battery cell inspection system, comprising:
a transport unit including a plurality of conveyors arranged in multiple levels in a vertical direction, and configured to transport a tray on which an assembled battery cell is mounted;
a cell inspection unit placed in stack corresponding to the multiple levels of the transport unit, and configured to perform pre-charging and cell defect inspection of the battery cell; and
a shuttle configured to move between the cell inspection unit and the transport unit to carry the tray into the cell inspection unit or take the tray from the cell inspection unit.

2. The battery cell inspection system according to claim 1, wherein the shuttle conveys a plurality of trays when performing an operation of carrying to the cell inspection unit once or an operation of taking from the cell inspection unit once.

3. The battery cell inspection system according to claim 2, wherein the shuttle is multiple levels corresponding to the transport unit and the cell inspection unit, and
wherein each of the multiple levels of the shuttle conveys at least one tray.

4. The battery cell inspection system according to claim 1, wherein the transport unit is disposed on a carry-in path and a carry-out path of the cell inspection unit.

5. The battery cell inspection system according to claim 3, wherein the transport unit includes:
a first transport conveyor; and
a second transport conveyor disposed vertically on the first transport conveyor.

6. The battery cell inspection system according to claim 5, wherein the cell inspection unit includes:
a first inspection device disposed at a height corresponding to the first transport conveyor; and
a second inspection device placed on the first inspection device and disposed at a height corresponding to the second transport conveyor.

7. The battery cell inspection system according to claim 6, wherein each of the first inspection device and the second inspection device includes:
a pin plate disposed on the tray and having a plurality of electrodes exposed;
a bottom plate configured to support the tray and spaced a predetermined distance apart from the pin plate; and
an up/down movement unit connecting the bottom plate to the pin plate, and configured to decrease or increase the distance between the bottom plate and the pin plate.

8. The battery cell inspection system according to claim 7, wherein each of the first inspection device and the second inspection device further includes a jig unit disposed on the bottom plate and configured to support and align the tray.

9. The battery cell inspection system according to claim 7, wherein the up/down movement unit includes:
a cylinder;
a rod having an end connected to the cylinder and an opposite end coupled to the bottom plate; and
a fixing block coupled to the bottom plate and configured to fix the opposite end of the rod.

10. The battery cell inspection system according to claim 8, wherein the jig unit includes:
a jig plate on which the tray is seated; and
a ratchet fastener configured to fix two sides of the tray seated on the jig plate when rotated.

11. The battery cell inspection system according to claim 10, wherein the jig unit further includes a stopper to limit movement in a direction of carrying the tray into the jig plate.

12. The battery cell inspection system according to claim 6, wherein a plurality of cell inspection units is arranged in a line.

13. The battery cell inspection system according to claim 12, wherein the shuttle moves in parallel to the lengthwise arrangement of the plurality of cell inspection units.

14. The battery cell inspection system according to claim 13, wherein the shuttle includes:
a body having a moving wheel;
a first carrying unit disposed at a height corresponding to the first transport conveyor and the first inspection device; and
a second carrying unit disposed at a height corresponding to the second transport conveyor and the second inspection device.

15. The battery cell inspection system according to claim 14, wherein each of the first carrying unit and the second carrying unit includes:
a pair of guide rails spaced apart from each other by a width of the tray;
a fork for gripping disposed slidably movably along the guide rails and configured to grip two sides of the tray; and
a fork driving unit configured to drive the fork for gripping.

16. The battery cell inspection system according to claim 15, wherein the fork for gripping moves from the body in a direction perpendicular to a movement direction of the shuttle.

17. The battery cell inspection system according to claim 1, wherein the cell defect inspection comprises causing a predetermined amount of current to flow in the battery cell, detecting a voltage change of the battery cell and determining a presence or absence of a defect.

18. The battery cell inspection system according to claim 1, wherein the battery cell includes an electrode assembly including a negative electrode plate, and
wherein the pre-charging comprises charging the battery cell in a predetermined amount to form an electric charge layer on the negative electrode plate to prevent formation of an electron movement channel by oxidation of metal impurities.

19. The battery cell inspection system according to claim 1, wherein the battery cell is a cylindrical battery.
